(19)

Europäisches
Patentamt
European
Patent Office
Office européen
des brevets

(11) **EP 2 221 963 A1**

(12) **EUROPEAN PATENT APPLICATION**

(43) Date of publication:
**25.08.2010 Bulletin 2010/34**

(51) Int Cl.:
*H03F 1/32* (2006.01)      *H04L 27/36* (2006.01)

(21) Application number: **07101802.2**

(22) Date of filing: **05.03.2007**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK RS** | (74) Representative: **Bergquist, Kjell Gunnar**<br>**Albihns.Zacco**<br>**Torggatan 8**<br>**Box 142**<br>**401 22 Göteborg (SE)** |
| (71) Applicant: **Nera networks**<br>**5020 Bergen (NO)** | <u>Remarks:</u><br>•The applicant contests the date of filing and the loss of the priority right.<br>•Amended claims in accordance with Rule 137(2) EPC. |
| (72) Inventor: **Lund, Sigurd Andre**<br>**5259, Hjellestad (NO)** | |

(54) **A predistorsion circuit for a radio transmitter**

(57)    The invention relates to a digital predistortion circuit (100, 200) for a radio transmitter, which receives a first (I) and a second (Q) data signal, that are to be modulated in a quadrature modulator and transmitted on one and the same carrier wave. The circuit comprises a means (110, 210) for combining the first (I) and second (Q) data signals with each other by means of a non-linear function, and a means for dividing up the output signal from the circuit into at least a first (111, 211) and a second (112, 212) branch, and means (121, 122) for multiplying the signals in the said at least first (111, 211) and second (112, 212) branches by first ($C_1$) and second ($C_2$) constants respectively. In a preferred embodiment, the non-linear function comprises multiplying the first and second data signals (I, Q) together.

**Fig 3**

EP 2 221 963 A1

**Description**

TECHNICAL FIELD

The invention relates to a digital predistortion circuit for a radio transmitter. The circuit receives a first and a second signal, and emits signals that are to be modulated in a quadrature modulator and transmitted on one and the same carrier wave.

BACKGROUND ART

In association with radio transmitters, dividing data streams into separate signals, so-called I signals and Q signals, is well known. These signals are transmitted phase-shifted from each other in the transmitter on one and the same carrier wave, where the phase shift between the signals is suitably ninety degrees, known as quadrature modulation.
It is very important to maintain analog insulation between the signals in the quadrature modulator. In traditional transmitters, the signals are processed in several steps, in other words the signals undergo frequency conversion in two or more steps before they attain the required transmission frequency, in other words a number of so-called intermediate frequencies are used.
In modern circuits, so-called MMIC-circuits (Monolithic Microwave Integrated Circuits) are used increasingly. The use of such circuits can cause problems with the insulation between the signals in the quadrature modulator.
In certain types of radio transmitters, it is also desirable to be able to go directly to the radio frequency, without the use of intermediate frequencies, which can also cause a reduced level of insulation between I and Q.
These two applications (MMIC and direct conversion to RF) are only examples of situations where a reduced level of insulation can arise.

DISCLOSURE OF INVENTION

As is apparent from the above, there is thus a need to be able to prevent poor insulation between the signals in a quadrature modulator in a radio transmitter in a better way than has previously been possible.
This need is met by the present invention in that it describes a digital predistortion circuit for a radio transmitter. The circuit according to the invention is intended to receive a first (I) and a second (Q) data signal, which are to be modulated in a quadrature modulator and transmitted on one and the same carrier wave.
The circuit according to the invention comprises a means for combining the first (I) and second (Q) data signals together utilizing a non-linear function, and a means for dividing up the output signal from the circuit into at least a first and a second branch, and comprises, in addition, means for ensuring that the signals in the said at least first and second branches are multiplied by first and second constants respectively.
In a preferred embodiment of the invention, the said non-linear function is multiplication.
The following detailed description will explain in greater detail how the invention solves the said problem.

BRIEF DESCRIPTION OF DRAWINGS

The invention will be described in greater detail in the following, with reference to the attached drawings, in which

Figures 1 and 2 show different embodiments of a predistortion circuit according to the invention, and
Figures 3 and 4 show examples of larger circuits in which the invention can be used, and
Figure 5 shows an alternative embodiment of the invention, and
Figure 6 shows yet another alternative embodiment of the invention.

MODES FOR CARRYING OUT THE INVENTION

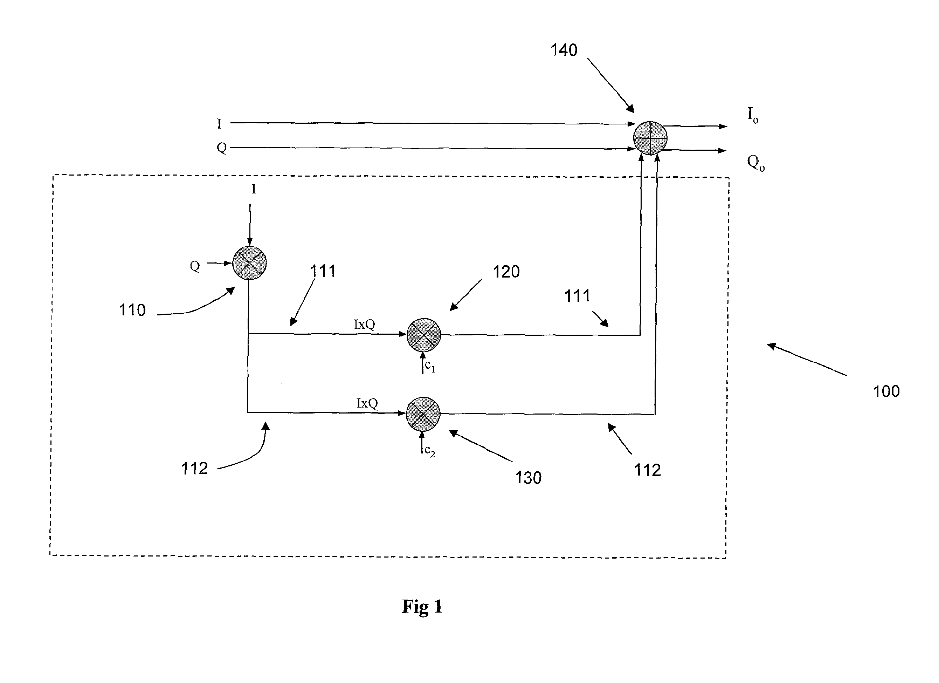

Figure 1 shows a first embodiment 100 of a circuit according to the invention, realized in digital technology. The object of the circuit 100 is to achieve output signals that can be used to correct a distortion that arises in a circuit (not shown), suitably a quadrature modulator, that modulates incoming data streams I and Q for transmission on a carrier wave.
The data stream that is to be modulated in the said modulator is divided into two different signals, called I and Q. These two signals, I and Q, are also connected to the circuit 100 according to the invention, so that the output signals from the circuit 100 can later be combined with the two signals, I and Q, that are to be modulated.
The incoming data stream that is to be modulated in the modulator (not shown) has thus been divided up into a first, I, and a second, Q, signal, preferably with different data in the two signals. The I and Q signals are connected to the circuit 100 according to the invention in the way that is described below.

In a traditional predistortion circuit, the two signals, I and Q, were squared individually and then added together. An addition can be regarded as a linear operation, which was thus carried out in a traditional circuit on the squares of the two signals. In other words, in a traditional circuit, a signal $z^2=I^2+Q^2$ was obtained.

In the circuit 100 according to the invention, a non-linear combining of the two data signals I and Q, is carried out instead in a device 110 for such combining, which is comprised in the circuit. This non-linear combining of I and Q can be carried out in a large number of different ways and still provide the desired effect, but, in a preferred embodiment of the invention, the combining device 110 is a multiplier that multiplies the I and Q signals together.

The multiplier 110 can be designed in a large number of different ways, that are well-known to experts within the field and will therefore not be described in detail here, but as an alternative to a pure multiplier circuit, "Look Up Tables" can be mentioned, in other words a table that contains the value of the product of two incoming numbers.

Other examples of non-linear combining of I and Q that could be carried out in the circuit 110 are, for example, to take the different signals as each other's exponents, in other words $I^Q$, or various types of trigonometrical functions, for example Q*sin(I). Yet other examples of possible such non-linear functions are a look-up table that has the I and Q values as input data, and that provides output data that is a function of I and Q, but that cannot be expressed by an analytical expression.

The output signal from the multiplier 110 is, in other words, the product I*Q of the two data streams. This output signal is divided up into a first 111 and a second 112 branch. In addition, the circuit 100 according to the invention comprises means 120, 130, for multiplying the signals in the said first 111 and second 112 branches by first $c_1$ and second $c_2$ constants respectively. These constants are calculated depending upon the application in question, and can be adjusted to ensure the predistortion function is appropriate for a specific quadrature modulator.

The means 120, 130 thus consist of multipliers, for the realization of which the above comments concerning the multiplier 110 apply.

In a subsequent quadrature modulator, the two input signals, I and Q, are quadrature modulated, which provides an output signal on the carrier wave frequency that will be used for transmission or possibly as an intermediate frequency. In the carrier wave, the two signals I and Q are to be phase-shifted in relation to each other, in a preferred embodiment with a phase difference of ninety degrees. With the input signals I and Q to the quadrature modulator, the required result of the modulation can be written, in other words, as I*cos($\omega$t) - Q*sin($\omega$t), where w represents the carrier wave frequency or an intermediate frequency.

The problem in the quadrature modulator that can be solved by means of a predistortion circuit 100 according to the invention is that each product of the two multiplications (the multiplication of the I signal and of the Q signal with a higher frequency) in the quadrature modulator contains components of the other signal and possibly unwanted functions of the signal itself, such as, for example, higher powers of this: in other words the product that should be I*cos($\omega$t) can contain components of the Q signal and, for example, unwanted powers of the I signal, and conversely the product that should be Q*sin($\omega$t) contains components of the I signal and, for example, unwanted powers of the Q signal. For example, an uncorrected output signal from the modulation of the I channel can appear as follows:

$$I*\cos(\omega t) + b*I*Q*\sin(\omega t) + a*I^2*\cos(\omega t)$$

where a and b are constants that specify the amount of non-linearity.

The object of the predistortion circuit 100 according to the invention is to "clean" the I and Q signals respectively of similar unwanted components after the quadrature modulator. For this purpose, by means of the circuit 100, the signals that are input to the quadrature modulator can be given an element of the "incorrect signal", in other words the I signal into the modulator can be made to contain Q components and higher powers of I, and the Q signal into the modulator can be made to contain I components and higher powers of Q.

As there is an element of both the signals, I and Q, in both the input signals I and Q to the quadrature modulator right from the start, the required result can be obtained, in other words the result of the leakage is eliminated to a considerable extent, so that the respective output signals from the modulator will essentially contain only the I signal or Q signal respectively multiplied by cosine or sine respectively.

The constants $c_1$ and $c_2$, by which the signals in the two branches 111, 112 respectively are multiplied, are chosen according to the assumed level of leakage in the modulator, and in other words are usually determined experimentally, although they can, of course, be determined in other ways, for example by being calculated or by being known empirically. In a preferred embodiment, the constants are real, positive or negative.

For the sake of completeness, Figure 1 also shows how the output signals in the two branches 111, 112 are used to provide corrected input signals to a subsequent quadrature modulator: a larger circuit that uses the circuit 100 according to the invention comprises a combiner 140 for combining the signal in the first branch 111 with one data signal I, and a means for combining the signal in the second branch 112 with the other data signal Q. In a preferred embodiment, the combiner 140 is an adder. The output signal from the adder 140 will thus be:

$$I_0 = ((I*Q)*c_1)+I$$

$$Q_0 = ((I*Q)*c_2)+Q$$

Thus, both $I_0$ and $Q_0$ will contain "correction factors", that can be varied, for example by means of the constants $c_1$ and $c_2$.

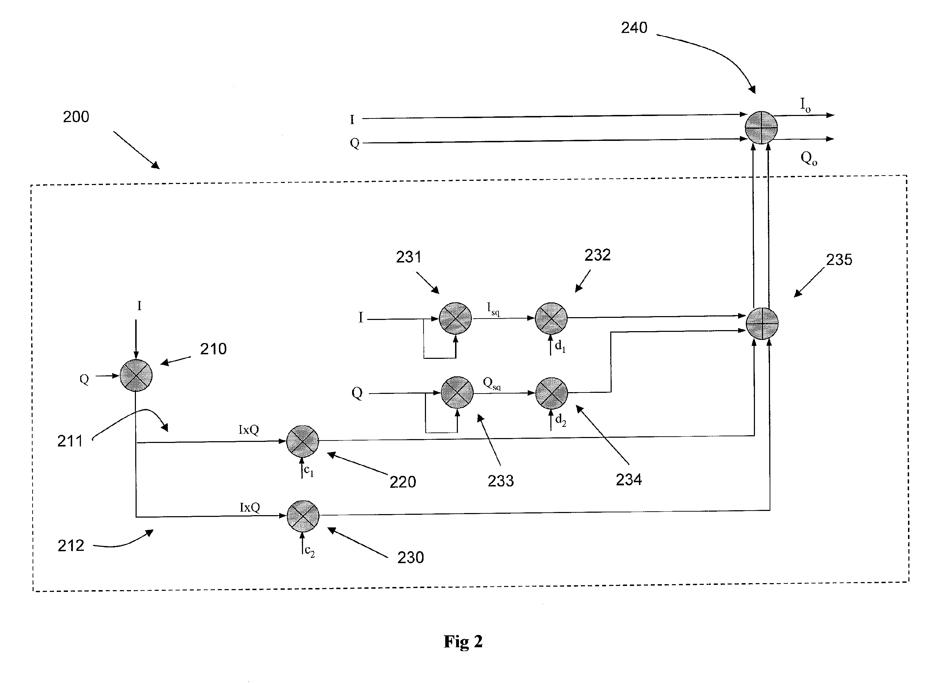

Figure 2 shows a second embodiment 200 of a predistortion circuit according to the invention. The circuit 200 has certain parts that are common to the circuit 100 in Figure 1 that will therefore not be described in detail, but in addition, in comparison with the circuit 100, the circuit 200 has been enlarged by a number of components that will be described in greater detail.

The circuit 200 thus comprises a combiner 210 for combining the signals I and Q with each other, where the output signal from the combiner is divided up into a first 211 and a second branch 212, and, in addition, it comprises means 220, 230, for multiplying the signal in each branch by a constant $c_1$ and $c_2$ respectively, which constants are produced in the same way as for the circuit 100. In a preferred embodiment of the invention, the combiner 210 is a multiplier.

As shown in Figure 2, in comparison with the circuit 100, the circuit 200 also comprises a means 235 in which the signal in one branch 111 is combined with a non-linear function of the first data stream I, and in which the signal in the other branch 112 is combined with a non-linear function of the second data stream Q.

The said non-linear function can be a number of different functions, but, in a preferred embodiment, is the product of a higher order power of the signals I and Q, and a first constant $d_1$, appropriate for the said power for the I stream, and a second constant $d_2$, appropriate for the said power for the Q stream, respectively.

In a preferred embodiment, the constants $d_1$ and $d_2$ are integers, positive or negative. The combining device 235 is also preferably an adder.

The higher order power of the signals I and Q respectively that are added to the signals in the adder 235 are adapted to the presence of any incorrect signals in the quadrature modulator for which the signals are to be input signals, where the incorrect signals are combined with the required output signal. The order of the power can, in other words, in principle be anything at all, but in the present case it has been observed that even powers occur in the quadrature modulator, preferably second order powers.

Thus, in a preferred embodiment, it is second order powers that are used in the adder 235, in other words $I^2*d_1$ is added to the signal in the first branch 211, and $Q^2*d_2$ is added to the signal in the second branch 212.

The circuit 200 thus comprises a squarer 231 for squaring the I stream, and a squarer 233 for squaring the Q stream, and also a multiplier 232 for multiplying the constant $d_1$ and the output signal from the squarer 231 and a multiplier 234 for multiplying the constant $d_2$ and the output signal from the squarer 233.

After the adder 235, the signals in the respective branches 211, 212, will thus contain both first and second order powers of the two signals I and Q. For the sake of completeness, the expressions for the signals in the two branches 211 and 212 after the adder 235 are given below:

• The expression for the signal in the branch 211 after the adder 235 is:

$$((I*Q)*c_1)+(I^2*d_1).$$

• The expression for the signal in the branch 212 after the adder 235 is:

$$((I*Q)*c_2)+(Q^2*d_2).$$

In the same way as for the circuit 100 in Figure 1, it is shown in Figure 2 how, by means of a combiner 240, the output signal from the circuit 200 in the first branch 211 is combined with the data signal I, and how the output signal from the circuit 200 in the second branch 212 is combined with the data signal Q, in order to create modified input signals

$I_0$ and $Q_0$ to a subsequent quadrature modulator. The combiner 240 is suitably an adder.

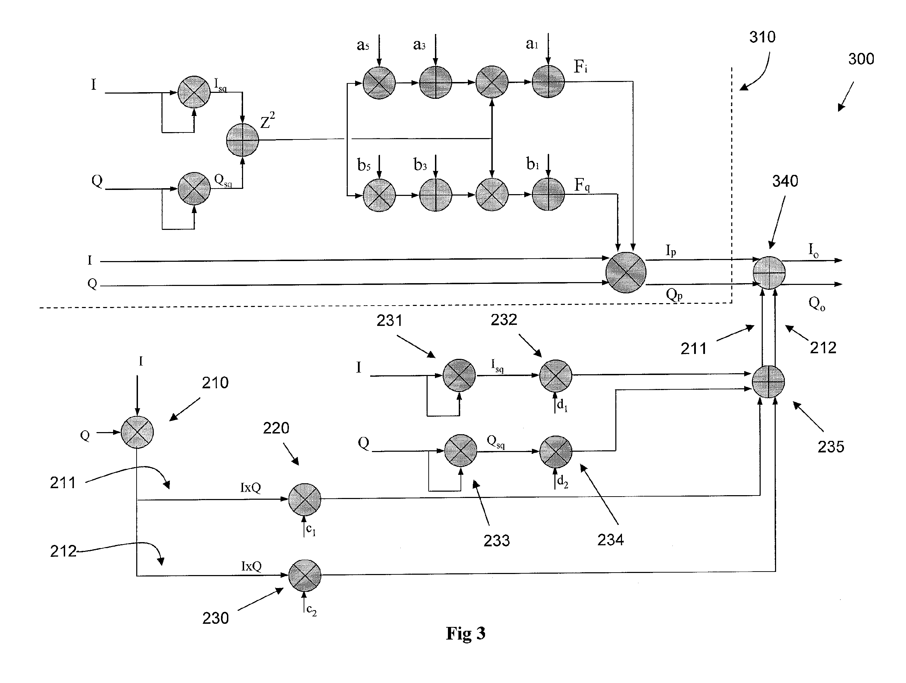

Figure 3 shows, for the sake of completeness, a larger circuit 300 that can include a predistortion circuit according to the invention, such as the one that was shown in Figure 2.

It should be pointed out that the circuit 300 is only one example of how the predistortion circuit according to the invention can be used. The invention can, of course, be used in a large number of different applications.

As shown in Figure 3, the circuit 300 comprises a separate "upper branch" 310, that is shown in a dotted box, for processing, normally digital signal processing, of the first, I, and second, Q, data streams that come into the circuit 300.

The second "upper" branch in Figure 3 can, in other words, provide an additional component to each of the (I/Q) input signals to the modulator. The object of introducing the processed signal from the upper branch is to correct errors in other components than in the quadrature modulator, in the same way as the signal processing in the circuit in Figures 1 and 2 was intended to correct errors in the quadrature modulator.

The other components for which the "upper branch" in Figure 3 corrects errors can be either before or after the quadrature modulator but, in a preferred embodiment, the upper branch is used to correct errors in an amplifier that comes after the modulator.

In other words, the signal processing in the upper branch can be designed in many different ways, depending upon the error that the signal from this branch is to compensate for, and can also be combined with the signal from the circuit from Figure 1 or 2 in different ways.

The circuit 300 in Figure 3 comprises a means 340 for combining a higher order polynomial of z (where $Z^2 = I^2 + Q^2$) from the upper branch 310 with the output signals from the branches 211 and 212 from the circuit 200 in Figure 2. $I_p$ and $Q_p$ (which are defined in greater detail below) thus come from the upper branch, with $I_p$ being combined with the signal in the first branch 211 and $Q_p$ being combined with the signal in the second branch 212.

In the embodiment 300 in Figure 3, the combiner 340 is an adder. For the sake of completeness, the expressions for the signals $I_p$ and $Q_p$ are given below:

$$I_p = I*F_i - Q*F_q$$

$$Q_p = Q*F_i + I*F_q$$

where

$$F_i = (z^4 a_5 + z^2 a_3 + a_1)$$

$$F_q = (z^4 b_5 + z^2 b_3 + b_1)$$

and where $a_1$-$a_5$ and $b_1$-$b_5$ are constants that are determined on the basis of the application in question.

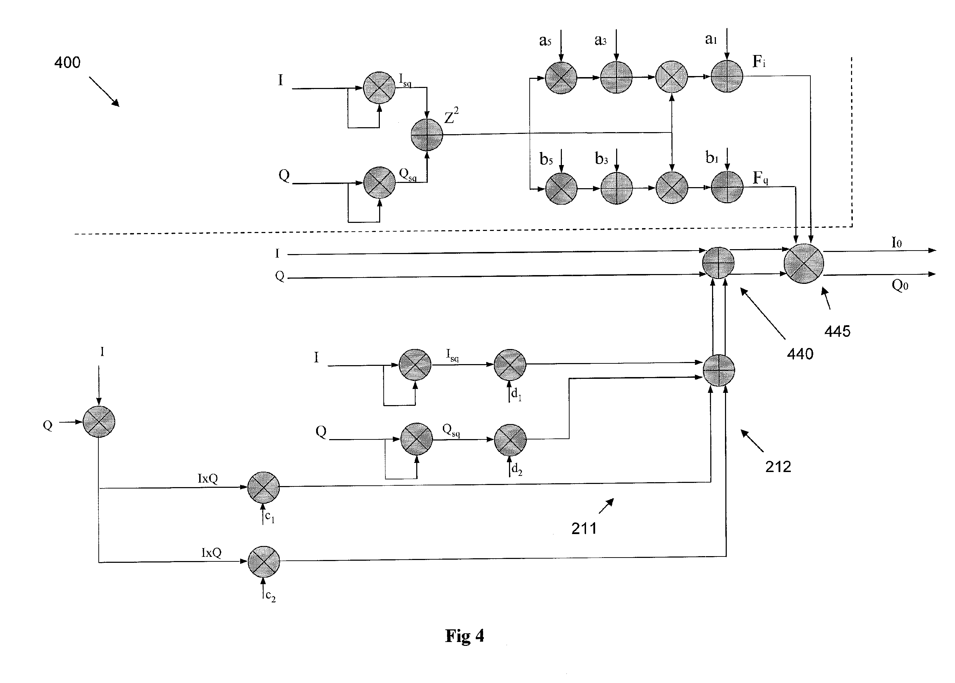

Figure 4 shows a variant 400 of the circuit 300 from Figure 3. The difference between the circuits 400 and 300 is that, in the circuit 400, the output signals in the two branches 211, 212, from the predistortion circuit according to the invention are first combined with the data signals I and Q respectively in a first combiner 440, and only thereafter is combining carried out of the two output signals using a higher order polynomial $F_i$, Fq, of z in a second combiner 445. The first combiner 440 is suitably an adder and the second combiner is suitably a multiplier 445.

In the circuit 400, the first combiner 440 can also either be an adder or a multiplier, but in the embodiment 400 in Figure 4, it is an adder.

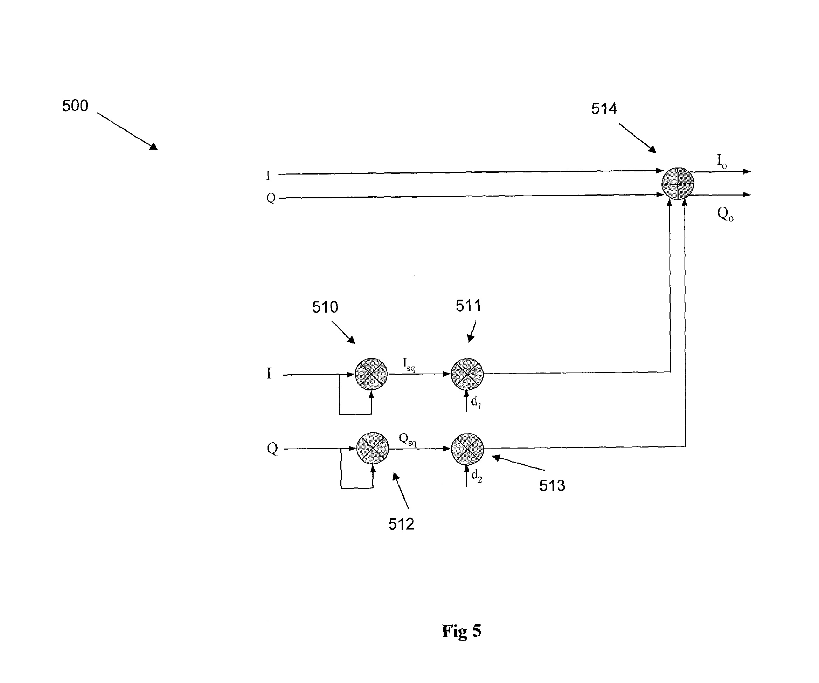

Figure 5 shows a variant 500 of a predistortion circuit according to the invention: this can in principle replace the predistortion circuit in all the embodiments that have been shown in Figures 1-4, if the type of predistortion signal that is generated by the circuit 500 is desirable instead of the type of predistortion signal that is generated by the previously-described circuits. For the sake of simplicity, the circuit 500 is only shown in one embodiment.

The circuit 500 receives the data signals I and Q in separate branches, and contains means 510, 512, for obtaining in principle any non-linear function of the respective data signals I and Q.

Figure 5 shows an example of the said non-linear function, namely means 510, 512 in each branch for squaring, followed by means 511, 513, for multiplying by a coefficient, so that $I^2*d_1$ is obtained in one branch, and $Q^2*d_2$ is obtained

in the other branch. These signals can thereafter be combined with I and Q respectively, either by addition or multiplication. Figure 5 shows an adder 514, by means of which

$$I_p = I + I^{2*}d_1$$

$$Q_p = Q + Q^{2*}d_2$$

are thus obtained.

These signals can thereafter be used as input signals to a quadrature modulator, which has an incorrect signal that corresponds to the square of the respective data signal in the example shown.

The invention is not restricted to the embodiments described above and shown in Figures 1-5, but can be varied freely within the framework of the following claims. For example, with reference to the circuit shown in Figure 1, the signals can be written as follows:

$$I_0 = ((I^*Q)^*c_1) + I$$

$$Q_0 = ((I^*Q)^*c_2) + Q$$

which can also be written as:

$$I_0 = I^*(Q^*c_1 + 1)$$

$$Q_0 = Q^*(I^*c_2 + 1)$$

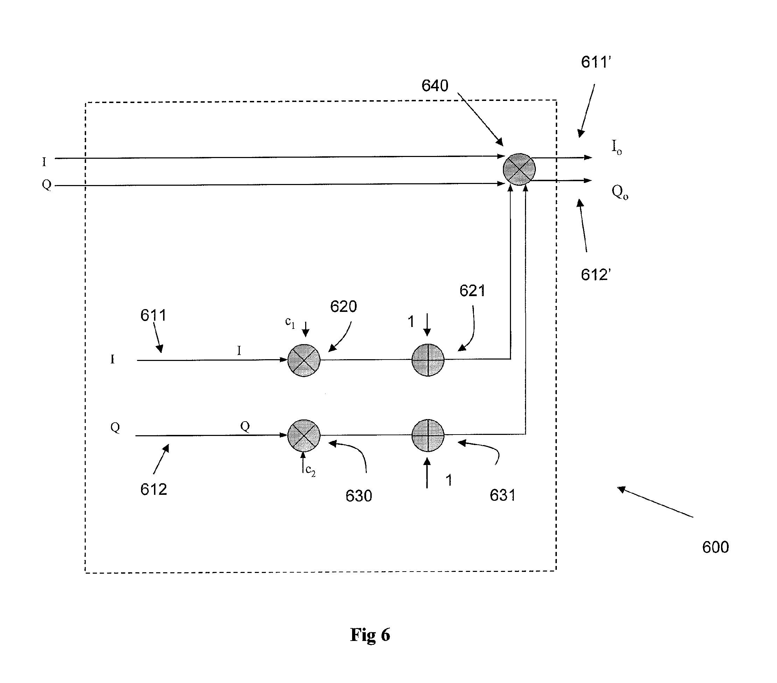

These expressions can be realized by means of the circuitry that is shown in Figure 6. The two signals I and Q come into the circuit 600 in the branches 611, 612 respectively, and are multiplied in the multipliers 620, 630 respectively, by constants $c_1$ and $c_2$ respectively. Thereafter, the signals are used as input signals to the adders 621, 631 respectively, for addition with 1.

Thus, in one branch the expression in one bracket above is obtained, and in the other branch the expression in the other bracket above is obtained, $Q^*c_1 + 1$ and $I^*c_2 + 1$ respectively. These two signals are then multiplied by I and Q respectively, in a multiplier 640, so that $I_0$ and $Q_0$ respectively are obtained.

In other words, the circuit 600 in Figure 6 contains all the characteristics of the predistortion circuits described above. The circuit 600 comprises a means 640 for combining the I and Q signals together by means of a non-linear function, that is multiplication in the example shown, and a means for dividing up the output signal from the combining process into at least a first $I_0$ and a second $Q_0$ branch.

In addition, it comprises means 620, 630 for ensuring that the signals in the said at least first 611 and second 612 branches are multiplied by first $c_1$ and second $c_2$ constants respectively. In this case, these means are multipliers.

It should be pointed out that, in a special embodiment, the constants $c_1$ and $c_2$ by which the signals are multiplied can equal 1, which is equivalent to an embodiment in which the multiplication is, in principle, omitted.

Depending upon the required output signal and on the embodiment, in principle all the combiners that are described in the embodiments above can be either adders or multipliers.

## Claims

1. A digital predistortion circuit (300, 400) for a radio transmitter, which receives a first (I) and a second (Q) data signal, that are to be modulated in a quadrature modulator and transmitted on one and the same carrier wave, which circuit comprises:

• an upper branch (310) comprising means for squaring the first (I) and second (Q) data signals, with subsequent combining so that a polynomial ($z^2$) that consists of the sum ($z^2=I^2+Q^2$) of the squared first (I) and second (Q) data signals is obtained;
• means in the upper branch for obtaining a higher order polynomial of the said sum ($z^2=I^2+Q^2$);
which digital predistortion circuit (100, 200, 600) is **characterized in that** it comprises in addition:
• means (110, 210, 640) for combining the first (I) and second (Q) data signals with each other by means of a non-linear function;
• an output signal from the combining in at least a first (111, 211, 611') and a second (112, 212, 612') branch;
• means (120, 220, 620; 130, 230, 630) for ensuring that the signals in the said at least first (111, 211, 611') and second (112, 212, 612') branches are multiplied by first ($c_1$) and second ($c_2$) constants respectively; and
• means (340, 445) for combining the said higher polynomial in the upper branch with the signals in the first and second branches respectively.

2. Predistortion circuit (100, 200, 600) according to claim 1, in which the means (340, 445) for combining the said higher polynomial in the upper branch with the signals in the first and second branches respectively are in the form of an adder and/or a multiplier.

3. Predistortion circuit (100, 200, 600) according to any one of claims 1 or 2, in which the said non-linear function (110, 210, 640) is multiplying the signals (I, Q) together.

4. Predistortion circuit (200) according to claim 1, further comprising a first combiner (235) for combining the signal in the first branch (211) with a non-linear function of the first data stream, and for combining the signal in the second branch (212) with a non-linear function of the second data stream, where the results of the said combinations are obtained as separate first and second output signals in the first and second branches respectively.

5. Circuit (200) according to claim 4, in which the said combiner (235) is an adder.

6. Circuit (200) according to claim 4, in which the said combiner (235) is a multiplier.

7. Predistortion circuit (200) according to any one of claims 4-6, in which the said non-linear function is a polynomial of the respective signal (I or Q), and a respective constant appropriate for this polynomial.

8. Predistortion circuit (200) according to claim 7, in which the said polynomial has only terms with an even power.

9. Predistortion circuit (200) according to claim 7 or 8, in which the said polynomial has only terms with second degree powers.

10. Circuit (400) comprising the predistortion circuit (100, 200) according to any one of claims 1-8, comprising in addition means (440) for combining the first data stream (I) with the signal in the first branch (111, 211) and for combining the second data stream (Q) with the signal in the second branch (112, 212).

11. Circuit (400) according to claim 10, in which the means (440) for combining is an adder.

12. Circuit (400) according to claim 10, in which the means (440) for combining is a multiplier.

13. Circuit (400) according to any one of claims 10-12, further comprising means (445) for adding or multiplying the signal in the first respective second branch with a higher order polynomial of $z^2$ after the said combining, where $z^2=I^2+Q^2$.


**Amended claims in accordance with Rule 137(2) EPC.**

1. A digital predistortion circuit (300, 400) for a radio transmitter, which receives a first (I) and a second (Q) data signal, that are to be modulated in a quadrature modulator and transmitted on one and the same carrier wave, which circuit comprises:

• an upper branch (310) comprising means for squaring the first (I) and second (Q) data signals, with subsequent combining so that a polynomial ($z^2$) that consists of the sum ($z^2=I^2+Q^2$) of the squared first (I) and second (Q) data signals is obtained;
• means in the upper branch for obtaining a higher order polynomial of the said sum ($z^2=I^2+Q^2$);

which digital predistortion circuit (100, 200, 600) is **characterized in that** it comprises in addition:

• means (110, 210, 640) for combining the first (I) and second (Q) data signals with each other by means of a non-linear function;
• an output of said means (210) for combining the first and second data signals being connected to at least a first (111, 211, 611') and a second (112, 212, 612') branch;
• means (120, 220, 620; 130, 230, 630) for ensuring that the signals in the said at least first (111, 211, 611') and second (112, 212, 612') branches are multiplied by first ($c_1$) and second ($c_2$) constants respectively; and
• means (340, 445) for combining the said higher polynomial in the upper branch with the signals in the first and second branches respectively.

**2.** Predistortion circuit (100, 200, 600) according to claim 1, in which the means (340, 445) for combining the said higher polynomial in the upper branch with the signals in the first and second branches respectively are in the form of an adder and/or a multiplier.

**3.** Predistortion circuit (100, 200, 600) according to any one of claims 1 or 2, in which the said non-linear function (110, 210, 640) is multiplying the signals (I, Q) together.

**4.** Predistortion circuit (200) according to claim 1, further comprising a first combiner (235) for combining the signal in the first branch (211) with a non-linear function of the first data signal, and for combining the signal in the second branch (212) with a non-linear function of the second data signal, where the results of the said combinations are obtained as separate first and second output signals in the first and second branches respectively.

**5.** Circuit (200) according to claim 4, in which the said combiner (235) is an adder.

**6.** Circuit (200) according to claim 4, in which the said combiner (235) is a multiplier.

**7.** Predistortion circuit (200) according to any one of claims 4-6, in which the said non-linear function is a polynomial of the respective signal (I or Q), and a respective constant appropriate for this polynomial.

**8.** Predistortion circuit (200) according to claim 7, in which the said polynomial has only terms with an even power.

**9.** Predistortion circuit (200) according to claim 7 or 8, in which the said polynomial has only terms with second degree powers.

**10.** Circuit (400) comprising the predistortion circuit (100, 200) according to any one of claims 1-8, comprising additional means (440) for combining the first data signal (I) with the signal in the first branch (111, 211) and for combining the second data signal (Q) with the signal in the second branch (112, 212).

**11.** Circuit (400) according to claim 10, in which the additional means (440) for combining is an adder.

**12.** Circuit (400) according to claim 10, in which the additional means (440) for combining is a multiplier.

**Fig 1**

EP 2 221 963 A1

Fig 2

Fig 3

EP 2 221 963 A1

Fig 4

EP 2 221 963 A1

Fig 5

**Fig 6**

EP 2 221 963 A1

**European Patent Office**

## EUROPEAN SEARCH REPORT

Application Number

EP 07 10 1802

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TEIKARI I ET AL: "Baseband digital predistorter with quadrature error correction" NORCHIP CONFERENCE, 2004. PROCEEDINGS OSLO, NORWAY 8-9 NOV. 2004, PISCATAWAY, NJ, USA,IEEE, 8 November 2004 (2004-11-08), pages 159-162, XP010791751 ISBN: 0-7803-8510-1 * page 159, right-hand column - page 161, left-hand column; figure 3 * | 1-13 | INV. H03F1/32 H04L27/36 |
| A | US 2002/050372 A1 (LEE JAE-HYUK [KR]) 2 May 2002 (2002-05-02) * figure 3 * | 1-13 | |
| A | WO 03/077496 A (ANDREW CORP [US]) 18 September 2003 (2003-09-18) * figure 3 * | 1-13 | |
| A | WO 03/030353 A (ROKE MANOR RESEARCH [GB]; DOMOKOS JOHN [GB]) 10 April 2003 (2003-04-10) * figure 2 * | 1-13 | TECHNICAL FIELDS SEARCHED (IPC) H03F H04L |

The present search report has been drawn up for all claims

| Place of search | Date of completion of the search | Examiner |
|---|---|---|
| Munich | 7 May 2007 | Dietsche, Stefan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

                                                                 
& : member of the same patent family, corresponding
    document

EPO FORM 1503 03.82 (P04C01)

**ANNEX TO THE EUROPEAN SEARCH REPORT
ON EUROPEAN PATENT APPLICATION NO.**                     EP 07 10 1802

This annex lists the patent family members relating to the patent documents cited in the above-mentioned European search report.
The members are as contained in the European Patent Office EDP file on
The European Patent Office is in no way liable for these particulars which are merely given for the purpose of information.

07-05-2007

| Patent document cited in search report | Publication date | Patent family member(s) | | Publication date |
|---|---|---|---|---|
| US 2002050372 A1 | 02-05-2002 | CN | 1341992 A | 27-03-2002 |
| WO 03077496 A | 18-09-2003 | AU | 2003213691 A1 | 22-09-2003 |
| | | CN | 1640086 A | 13-07-2005 |
| | | DE | 10392344 T5 | 21-04-2005 |
| | | GB | 2401520 A | 10-11-2004 |
| | | US | 7197085 B1 | 27-03-2007 |
| WO 03030353 A | 10-04-2003 | EP | 1430597 A2 | 23-06-2004 |
| | | GB | 2381682 A | 07-05-2003 |
| | | US | 2005127995 A1 | 16-06-2005 |

EPO FORM P0459

For more details about this annex : see Official Journal of the European Patent Office, No. 12/82